# EUROPÄISCHE PATENTSCHRIFT

(11) **EP 0 580 933 B1**
(45) Veröffentlichungstag und Bekanntmachung des Hinweises auf die Patenterteilung: **26.08.1998**
(21) Anmeldenummer: 93100601.9
(22) Anmeldetag: 16.01.1993
(51) Int. Cl.: H03F 3/21, H03F 1/02

(54) **Schaltungsanordnung zur Reduzierung des Energieverbrauches in einem analogen Verstärker**
Circuit device for reducing power consumption in an analog amplifier
Dispositif de circuit pour la reduction de la consommation d'énergie d'un amplificateur analoge

(30) Priorität: 22.07.1992 DE 4224111
(43) Veröffentlichungstag der Anmeldung: 02.02.1994
(73) Patentinhaber: VDO LUFTFAHRTGERÄTE WERK GmbH, D-60391 Frankfurt (DE)
(72) Erfinder: Bager, Ralf, W-6000 Frankfurt (Main) (DE)
(74) Vertreter: Gornott, Dietmar, Dipl.-Ing.

(56) Entgegenhaltungen:
- DE-A- 2 904 231
- FR-A- 2 641 425
- US-A- 3 488 551
- US-A- 4 158 179
- US-A- 4 581 565
- ELEKTOR ELECTRONICS. Bd. 5, Nr. 7/8, Juli 1979, CANTERBURY GB Seite 7.37 G. SCHMIDT 'CURRENT DUMPING AMPLIFIER 48'

## Beschreibung

Die Erfindung bezieht sich auf eine Schaltungsanordnung zur Reduzierung des Energieverbrauchs in einem analogen Verstärker, welcher eine lineare oder nichtlineare komplexe Last ansteuert, wobei dem Verstärker eine erste und eine zweite Versorgungsspannung verschiedener Polarität zuführbar sind. Solche Lasten sind beispielsweise Spulen, Kondensatoren und Motoren.

Jedem Verstärker haftet der Nachteil des Energieverlustes durch Wärme an, der umso größer ist, je extremer die Betriebsbedingungen für die Schaltung sind.

Bei Leistungsverstärkern steht eine hohe Ausgangsleistung der Schaltung im Vordergrund. Dabei kommt die Leistungsverstärkung selbst durch eine hohe Stromverstärkung zustande. Ausgangsspannung und Ausgangsstrom sollen sowohl positive als auch negative Werte annehmen können.

Eine besonders kritische Situation entsteht dann, wenn die Last Energie an die Endstufe zurückspeisen kann, z.B. bei positiver Ausgangsspannung den negativen Maximalstrom in den Leistungsverstärker einspeist. Dieser Fall tritt bei der Ansteuerung von Spulen, Kondensatoren und Motoren auf. Die Ansteuerung erfordert somit höchst unterschiedliche, teilweise widersprüchliche Eigenschaften.

Ein Leistungsverstärker für die eingangs beschriebenen extremen Anforderungen ist aus Tietze, Schenk "Halbleiter-Schaltungstechnik" Springer-Verlag Berlin, Heidelberg, New York 1990, 9. Auflage, Kapitel 17.6, S. 525 ff, bekannt. In jeden komplementären Zweig wird zwischen den jeweiligen Endstufentransistor und die Betriebsspannung ein Transistor in Reihe geschaltet. Der Kollektor des Endstufentransistors und der Emitter des zusätzlichen Transistors sind über eine Diode mit Masse verbunden. Aufgrund dieser Kombination ist es möglich, die Steuerung des Verstärkers über die Eingangsspannung durchzuführen und somit die Verlustleistung zu senken. Bei einem anderen bekannten Verstärker dieser Art nach US 3,488,551 erfolgt die Verbindung über die Diode mit einer niedrigeren Spannung als die Betriebsspannung.

Außerdem ist durch US 4,158,179 ein Verstärker bekanntgeworden, bei dem Endstufen parallelgeschaltet sind, die mit unterschiedlichen Betriebsspannungen versorgt werden.

Nachteilig wirkt sich hierbei aus, daß eine schaltungstechnische Veränderung des Leistungsverstärkers selbst notwendig ist.

Der Erfindung liegt die Aufgabe zugrunde, eine Schaltungsanordnung zur Reduzierung des Energieverbrauches An einem analogen Verstärker zu schaffen, die bei der Ansteuerung von Lasten mit den unterschiedlichsten Eigenschaften bei allen Betriebszuständen die größte Energieeinsparung gewährleistet. Dabei soll der Leistungsverstärker selbst nicht verändert werden.

Die Aufgabe wird bei einer ersten erfindungsgemäßen Schaltungsanordnung dadurch gelöst,
- daß der Ausgang des Verstärkers mit dem Eingang einer Stromquellenschaltung verbunden ist, die über ihren Ausgang mit der Last verbunden ist und der Versorgungsspannungen zuführbar sind,
- daß mindestens eine der Versorgungsspannungen (U_{S1}; U_{S2}) der Stromquellenschaltung dem Betrage nach niedriger als die bezüglich ihrer Polarität entsprechende Versorgungsspannung (U_{V1}; U_{V2}) des Verstärkers ist, wobei die andere Versorgungsspannung (U_{S2}; U_{S1}) der Stromquellenschaltung dem Betrage nach nicht größer als die andere Versorgungsspannung (U_{V2}; U_{V1}) des Verstärkers ist, und
- daß die Stromquellenschaltung bei Energieabgabe an die Last in Abhängigkeit von der Ausgangsspannung des Verstärkers
   - entweder eine leitende Verbindung zwischen ihrem Eingang und ihrem Augang herstellt, wenn die Ausgangsspannung des Verstärkers größer als die Versorgungsspannung der Stromquellenschaltung mit jeweils gleicher Polarität ist, so daß der Verstärker den Laststrom liefert, der durch die Stromquellenschaltung hindurchfließt;
   - oder als linearer Verstärker arbeitet und hierbei den Laststrom aus ihren Versorgungsspannungen entnimmt, wenn die Ausgangsspannung des Verstärkers nicht größer als die Versorgungsspannung der Stromquellenschaltung mit jeweils gleicher Polarität ist, so daß der Verstärker dann nur einen Steuerstrom liefert.

Eine vorteilhafte Ausgestaltung dieser Schaltungsanordnung besteht darin, daß der Eingang der Stromquellenschaltung einerseits mit der Basis eines ersten Transistors (T_{S1}) verbunden ist, dessen Kollektor an die Kathode einer ersten Diode (D_{S1}) führt und deren Anode an der ersten Betriebsspannung (U_{S1}) liegt und der Emitter des ersten Transistors (T_{S1}) mit der Last (L) verbunden ist, und andererseits mit der Basis eines zweiten Transistors (T_{S2}) verbunden ist, dessen Kollektor mit der Anode einer zweiten Diode (D_{S2}) verbunden ist, deren Kathode an die zweite Betriebsspannung (U_{S2}) führt, wobei der Emitter des zweiten Transistors (T_{S2}) an die Last angeschlossen ist. Der erste Transistor ist dabei vom npn-Typ und der zweite vom pnp-Typ.

Die erfindungsgemäße Schaltungsanordnung ermöglicht die Entnahme des größten Teiles des Laststromes aus der Stromquellenschaltung. Der Verstärker liefert nur noch einen geringen Strom, so daß die thermische Belastung des Verstärkers auf ein Minimum beschränkt wird, während der Hauptanteil des Stromes energietechnisch günstig aus niedrigerer Spannung entnommen werden kann. Die Schaltungsanordnung stellt sich auf die durch die jeweils zu steuernde Last vorgegebenen Bedingungen ein und steuert die notwendigen Ströme selbsttätig. Das bedeutet, daß sie sowohl für ohmsche Lasten als auch für Spulen, Kondensatoren und Motoren gleichermaßen einsetzbar ist.

Bei einer zweiten erfindungsgemäßen Schaltungsanordnung wird die Aufgabe dadurch gelöst,
- daß der Ausgang des Verstärkers mit dem Eingang einer Stromquellenschaltung verbunden ist, die über ihren Ausgang mit der Last verbunden ist und der eine Versorgungsspannung zuführbar ist,
- daß die Versorgungsspannung (U_{S1}) der Stromquellenschaltung dem Betrage nach niedriger als die bezüglich ihrer Polarität entsprechende Versorgungsspannung (U_{V1}; U_{V2}) des Verstärkers ist und
- daß die Stromquelenschaltung bei Energieabgabe an die Last in Abhängigkeit von der Ausgangsspannung des Verstärkers
   - entweder eine leitende Verbindung zwischen ihrem Eingang und ihrem Augang herstellt, wenn die Ausgangsspannung des Verstärkers bei gleicher Polarität größer als die Versorgungsspannung der Stromquellenschaltung ist oder entgegengesetzte Polarität aufweist, so daß der Verstärker den Laststrom liefert, der durch die Stromquellenschaltung hindurchfließt;
   - oder als linearer Verstärker arbeitet und hierbei den Laststrom aus ihren Versorgungsspannungen entnimmt, wenn die Ausgangsspannung des Verstärkers bei gleicher Polarität nicht größer als die Versorgungsspannung der Stromquellenschaltung entgegengesetzter Polarität ist, so daß der Verstärker dann nur einen Steuerstrom liefert.

Eine vorteilhafte Ausgestaltung dieser Schaltungsanordnung besteht darin, daß der Eingang der Stromquellenschaltung einerseits mit der Basis eines Transistors (T_{S1}) verbunden ist, dessen Kollektor an die Kathode einer ersten Diode (D_{S1}) führt und deren Anode an der ersten Betriebsspannung (U_{S1}) liegt und der Emitter des Transistors (T_{S1}) mit der Last (L) verbunden ist, und daß andererseits der Emitter des Transistors (T_{S1}) mit der Anode einer weiteren Diode (D_{S9}) verbunden ist, deren Kathode an die Basis des Transistors (T_{S1}) angeschlossen ist.

Zur Erzielung einer Energieeinsparung kann es im Einzelfall zweckmäßig sein, nur eine der Versorgungspannungen der Stromquellenschaltung niedriger als die entsprechende Versorgungsspannung des Verstärkers zu wählen. Bei ansonsten symmetrischen Verhältnissen kann gemäß einer vorteilhaften Ausgestaltung vorgesehen sein, daß beide Versorgungsspannungen der Stromquellenschaltung dem Betrage nach niedriger als die Versorgungsspannungen des Verstärkers sind.

Eine energetisch sehr günstige Variante ergibt sich durch eine Weiterbildung der Erfindung, die darin besteht, daß zwischen den Verstärker und die Last mehrere kaskadierte Stromquellenschaltungen geschaltet sind und daß mindestens eine der Versorgungsspannungen einer zweiten und gegebenenfalls jeweils einer weiteren Stromquellenschaltung niedriger ist als die bezüglich ihrer Polarität entsprechende Versorgungsspannung der jeweils vorgeschalteten Stromquellenschaltung, wobei die jeweils andere Versorgungsspannung nicht größer als die andere Versorgungsspannung der jeweils vorgeschalteten Stromquellenschaltung ist.

Auch dabei kann vorgesehen sein, daß beide Versorgungsspannungen einer zweiten und gegebenenfalls jeweils einer weiteren Stromquellenschaltung niedriger sind als die Versorgungsspannungen der jeweils vorgeschalteten Stromquellenschaltung.

Diese Kaskadierung der Stromquellenschaltung stellt sicher, daß je nach dem konkreten Betriebszustand der Laststrom immer aus der für diesen Betriebszustand niedrigsten Spannungsquelle entnommen wird. Das bedeutet, daß immer die verlustleistungsärmste Variante im konkreten Betriebszustand selbsttätig zur Anwendung kommt.

Da die Stromquellenschaltung außer den Transistoren keine weiteren frequenzbestimmenden Elemente aufweist, ist ein Einsatz der Schaltung bei niedrigen Frequenzen möglich.

Um sicher zu verhindern, daß die Transistoren in Sättigung gehen, ist in einer Ausgestaltung vorgesehen, daß der Kollektor des ersten Transistors mit der Kathode einer dritten Diode verbunden ist, deren Anode an die Basis des ersten Transistors führt, während der Kollektor des zweiten Transistors des komplementären Schaltungsteils mit der Anode einer vierten Diode verbunden ist, deren Kathode an der Basis dieses Transistors liegt.

Als Stromquellentransistoren können insbesondere bei hohen Spannungen Feldeffekttransistoren eingesetzt werden.

Eine genaue Einstellung des Stromverhältnisses aus Verstärker und Stromquellenschaltung erfolgt, indem zwischen die Basis und den Emitter des ersten Transistors oder des zweiten Transistors ein Widerstand geschaltet ist. Der Widerstand kann durch einen Kondensator ergänzt werden.

Es ist vorteilhaft, am Ausgang der Stromquellenschaltung Freilaufdioden vorzusehen. Dabei ist der Ausgang der Stromquellenschaltung einerseits mit der Anode einer ersten Freilaufdiode, deren Kathode an der ersten Betriebsspannung des Verstärkers liegt, verbunden, andererseits an die Kathode einer zweiten Freilaufdiode angeschlossen ist, deren Anode auf die zweite Betriebsspannung des Verstärkers führt.

Durch die Freilaufdioden wird ein Rückwärtsstrom in die Energiebilanz der Schaltung eingebracht. Für den Fall, daß in der Last ein Energieabbau erfolgt, wird dieser Strom bei Vollaussteuerung über die Freilaufdioden in der Spannungsquelle des Verstärkers zwischengespeichert.

Vorteilhafterweise kann die erfindungsgemäße Schaltungsanordnung im AB-Betrieb betrieben werden.

Der Ausgang jeder Stromquellenschaltung kann zur Kennlinienverbesserung der Schaltung in einen Rückkopplungspfad einbezogen werden.

Die Erfindung läßt zahlreiche Ausführungsformen zu. Zu ihrer weiteren Verdeutlichung sind zwei davon in der Zeichnung dargestellt und werden nachfolgend beschrieben.

Die Zeichnung zeigt in
- Fig. 1: zweistufige, symmetrisch aufgebaute Energiesparschaltung für einen Ablenkverstärker
- Fig. 2: Energiesparschaltung nur an einer Spannungsquelle.

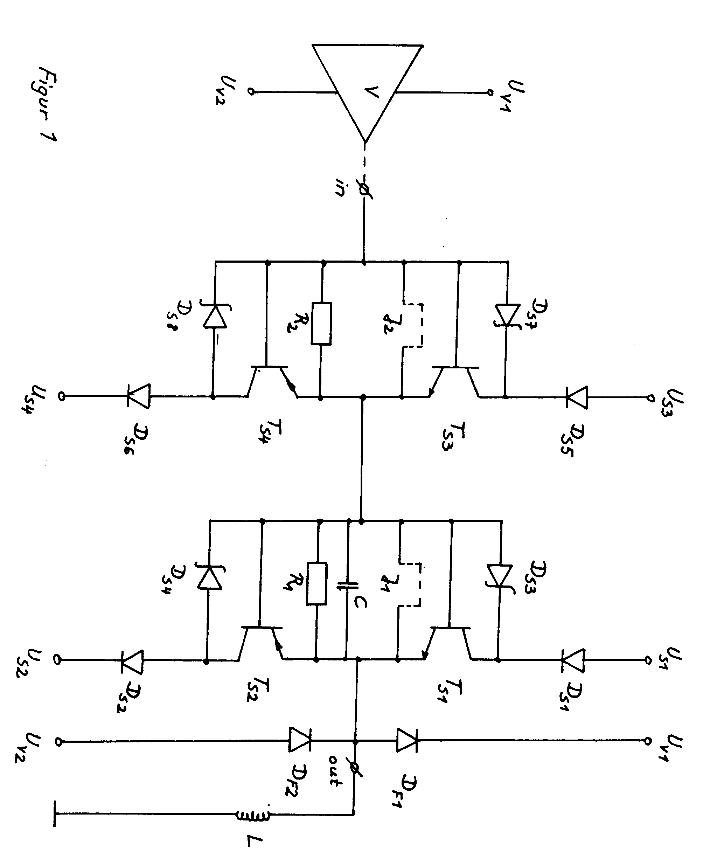

Die in Fig. 1 gezeigte Energiesparschaltung für Ablenkverstärker eignet sich zur Ansteuerung der Ablenkspule einer Bildröhre. Die Bilddarstellung soll mittels der Ablenksignale rotiert bzw. gekippt werden, so daß die üblichen Schaltungen nicht anzuwenden sind.

Bei Ablenkverstärkern treten im wesentlichen 3 Betriebszustände auf, für die Spannungen in unterschiedlicher Größenordnung notwendig sind, da aufgrund der physikalischen Gesetzmäßigkeiten die maximale Ablenkgeschwindigkeit der angesteuerten Spule proportional zur verfügbaren Spannung ist.

Der reguläre Ablenkverstärker arbeitet auf einer Betriebsspannung von ± 31 V. Die Energiesparschaltung selbst besteht aus 2 Stufen, wobei die dem Verstärker zugewandte Stufe bei einer Betiebsspannung von ± 12 V und die der Last zugewandten Stufe bei einer Betriebsspannung von ± 3,5 V betrieben werden.

Die erfindungsgemäße Schaltung wird nachfolgend für den Fall der positiven Spannungen erläutert. Bei negativen Spannungen arbeitet die Schaltungsanordnung aufgrund des komplementären Aufbaus analog.

Für den normalen Betriebsfall des Zeilenvorlaufes liegt am Emitter des Transistors T_{S1} der ersten Stufe, welche auf einer Betriebsspannung von 3,5 V arbeitet, eine Spannung von 10 V an. Aufgrund des anliegenden hohen Potentials koppelt die Diode D_{S1} die 3,5 V-Spannungsquelle ab. Die Schottkydiode D_{S3} steuert durch und der notwendige Arbeitsstrom fließt aus der zweiten Stufe der erfindungsgemäßen Schaltungsanordnung, welche bei einer Betriebsspannung von 12 V arbeitet, über die Schottkydiode D_{S3} und die Rolletor-Emitter-Strecke des Transistors T_{S1} der ersten Stufe in die Ablenkspule.

Für den Fall des schnellen Zeilenrücklaufes, wo eine Spannung von 31 V benötigt wird, sperrt die Diode D_{S5} der zweiten Stufe und der Strom fließt zwischen Verstärker V, Freilaufdiode D_{F1} und Ablenkspule L.

Beim schnellen Zeilenrücklauf wird die abgebaute Spulenenergie über die Freilaufdiode D_{F1} der 31 V-Spannungsquelle zugeführt und sodann mit umgekehrten Vorzeichen wieder der Spule zur Verfügung gestellt. Für den Zeilenrücklauf ergibt sich somit der minimalste Energieverbrauch.

Für die Erzeugung des Haltestromes der Ablenkspule reichen die 3,5 V-Betriebsspannung der ersten Stufe aus. Zur Gewichtung der Ströme ist in jeder Schaltungsstufe ein Widerstand R₁ bzw. R₂ zwischen Basis und Emitter der Transistoren T_{S2} der ersten Stufe bzw. T_{S4} der zweiten Stufe geschaltet. Über eine Brücke J₁ bzw. J₂, die zwischen Basis und Emitter der ersten Transistoren T_{S1} und T_{S3} jeder Stufe angeordnet ist, kann jede Schaltungsstufe deaktiviert werden.

Für den normalen Betriebsfall wird mit der energetisch günstigen 12 V-Stromquelle gearbeitet. Der Verstärker selbst wird nur im seltenen Fall des Zeilenrücklaufs belastet.

Die Schaltungsanordnung gewährleistet, daß der Ausgangsstrom stets aus der niedrigstmöglichen Betriebsspannung hinzugefügt wird.

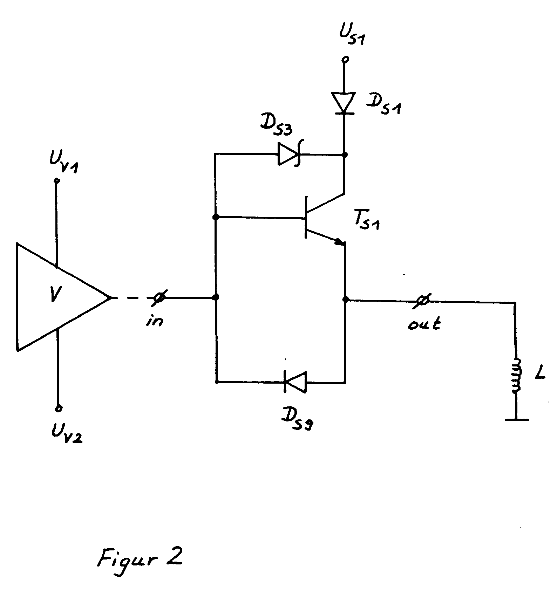

Gemäß Fig. 2 ist eine Möglichkeit dargestellt, die erfindungsgemäße Schaltungsanordnung mit nur einer Spannungsquelle U_{S1} zu betreiben. Die Funktion des Transistors T_{S2} wird hierbei durch die Diode D_{S9} übernommen.

Die erfindungsgemäße Schaltungsanordnung eignet sich sehr gut zum Einsatz in einer Brückenschaltung.

## Patentansprüche

1. Schaltungsanordnung zur Reduzierung des Energieverbrauchs in einem analogen Verstärker, welcher eine lineare oder nichtlineare komplexe Last ansteuert, wobei dem Verstärker eine erste (U_{V1}) und eine zweite (U_{V2}) Versorgungsspannung verschiedener Polarität zuführbar sind, dadurch gekennzeichnet,
- daß der Ausgang des Verstärkers mit dem Eingang einer Stromquellenschaltung verbunden ist, die über ihren Ausgang mit der Last verbunden ist und der Versorgungsspannungen zuführbar sind,
- daß mindestens eine der Versorgungsspannungen (U_{S1}; U_{S2}) der Stromquellenschaltung dem Betrage nach niedriger als die bezüglich ihrer Polarität entsprechende Versorgungsspannung (U_{V1}; U_{V2}) des Verstärkers ist, wobei die andere Versorgungsspannung (U_{S2}; U_{S1}) der Stromquellenschaltung dem Betrage nach nicht größer als die andere Versorgungsspannung (U_{V2}; U_{V1}) des Verstärkers ist, und
- daß die Stromquellenschaltung bei Energieabgabe an die Last in Abhängigkeit von der Ausgangsspannung des Verstärkers
- entweder eine leitende Verbindung zwischen ihrem Eingang und ihrem Augang herstellt, wenn die Ausgangsspannung des Verstärkers größer als die Versorgungsspannung der Stromquellenschaltung mit jeweils gleicher Polarität ist, so daß der Verstärker den Laststrom liefert, der durch die Stromquellenschaltung hindurchfließt;
- oder als linearer Verstärker arbeitet und hierbei den Laststrom aus ihren Versorgungsspannungen entnimmt, wenn die Ausgangsspannung des Verstärkers nicht größer als die Versorgungsspannung der Stromquellenschaltung mit jeweils gleicher Polarität ist, so daß der Verstärker dann nur einen Steuerstrom liefert.

2. Schaltungsanordnung nach Anspruch 1, dadurch gekennzeichnet, daß der Eingang der Stromquellenschaltung einerseits mit der Basis eines ersten Transistors (T_{S1}) verbunden ist, dessen Kollektcr an die Kathode einer ersten Diode (D_{S1}) führt und deren Anode an der ersten Betriebsspannung (U_{S1}) liegt und der Emitter des ersten Transistors (T_{S1}) mit der Last (L) verbunden ist, und andererseits mit der Basis eines zweiten Transistors (T_{S2}) verbunden ist, dessen Kollektor mit der Anode einer zweiten Diode (D_{S2}) verbunden ist, deren Kathode an die zweite Betriebsspannung (U_{S2}) führt, wobei der Emitter des zweiten Transistors (T_{S2}) an die Last angeschlossen ist.

3. Schaltungsanordnung zur Reduzierung des Energieverbrauchs in einem analogen Verstärker, welcher eine lineare oder nichtlineare komplexe Last ansteuert, wobei dem Verstärker eine erste (U_{V1}) und eine zweite (U_{V2}) Versorgungsspannung verschiedener Polarität zuführbar sind, dadurch gekennzeichnet,
- daß der Ausgang des Verstärkers mit dem Eingang einer Stromquellenschaltung verbunden ist, die über ihren Ausgang mit der Last verbunden ist und der eine Versorgungsspannung zuführbar ist,
- daß die Versorgungsspannung (U_{S1}) der Stromquellenschaltung dem Betrage nach niedriger als die bezüglich ihrer Polarität entsprechende Versorgungsspannung (U_{V1}; U_{V2}) des Verstärkers ist und
- daß die Stromquellenschaltung bei Energieabgabe an die Last in Abhängigkeit von der Ausgangsspannung des Verstärkers
- entweder eine leitende Verbindung zwischen ihrem Eingang und ihrem Augang herstellt, wenn die Ausgangsspannung des Verstärkers bei gleicher Polarität größer als die Versorgungsspannung der Stromquellenschaltung ist oder entgegengesetzte Polarität aufweist, so daß der Verstärker den Laststrom liefert, der durch die Stromquellenschaltung hindurchfließt;
- oder als linearer Verstärker arbeitet und hierbei den Laststrom aus ihren Versorgungsspannungen entnimmt, wenn die Ausgangsspannung des Verstärkers bei gleicher Polarität nicht größer als die Versorgungsspannung der Stromquellenschaltung entgegengesetzter Polarität ist, so daß der Verstärker dann nur einen Steuerstrom liefert.

4. Schaltungsanordnung nach Anspruch 3, dadurch gekennzeichnet, daß der Eingang der Stromquellenschaltung einerseits mit der Basis eines Transistors (T_{S1}) verbunden ist, dessen Kollektor an die Kathode einer ersten Diode (D_{S1}) führt und deren Anode an der ersten Betriebsspannung (U_{S1}) liegt und der Emitter des Transistors (T_{S1}) mit der Last (L) verbunden ist, und daß andererseits der Emitter des Transistors (T_{S1}) mit der Anode einer weiteren Diode (D_{S9}) verbunden ist, deren Kathode an die Basis des Transistors (T_{S1}) angeschlossen ist.

5. Schaltungsanordnung nach Anspruch 1, dadurch gekennzeichnet, daß beide Versorgungsspannungen (U_{S1}; U_{S2}) der Stromquellenschaltung dem Betrage nach niedriger als die Versorgungsspannungen (U_{V1}; U_{V2}) des Verstärkers sind.

6. Schaltungsanordnung nach Anspruch 1, dadurch gekennzeichnet, daß zwischen den Verstärker und die Last mehrere kaskadierte Stromquellenschaltungen geschaltet sind und daß mindestens eine der Versorgungsspannungen (U_{S3}; U_{S4}) einer zweiten und gegebenenfalls jeweils einer weiteren Stromquellenschaltung dem Betrage nach niedriger ist als die bezüglich ihrer Polarität entsprechende Versorgungsspannung (U_{S1}; U_{S2}) der jeweils vorgeschalteten Stromquellenschaltung, wobei der Betrag der jeweils anderen Versorgungsspannung (U_{S4}; U_{S3}) nicht größer als der Betrag der anderen Versorgungsspannung (U_{S2}; U_{S1}) der jeweils vorgeschalteten Stromquellenschaltung ist.

7. Schaltungsanordnung nach Anspruch 5, dadurch gekennzeichnet, daß beide Versorgungsspannungen (U_{S3}; U_{S4}) einer zweiten und gegebenenfalls jeweils einer weiteren Stromquellenschaltung dem Betrage nach niedriger sind als die Versorgungsspannungen (U_{S1}; U_{S2}) der jeweils vorgeschalteten Stromquellenschaltung.

8. Schaltungsanordnung nach Anspruch 2, dadurch gekennzeichnet, daß der Kollektor des ersten Transistors (T_{S1}) mit der Kathode einer dritten Diode (D_{S3}) verbunden ist, deren Anode an die Basis des Transistors (T_{S1}) führt, während der Kollektor des zweiten Transistors (T_{S2}) mit der Anode einer vierten Diode (D_{S4}) verbunden ist, deren Kathode an der Basis dieses Transistors liegt.

9. Schaltungsanordnung nach einem der Ansprüche 2 oder 4, dadurch gekennzeichnet, daß die Transistoren (T_{S1}, T_{S2}) Feldeffekttransistoren sind.

10. Schaltungsanordnung nach Anspruch 2, dadurch gekennzeichnet, daß zwischen die Basis und den Emitter des ersten Transistors (T_{S1}) oder des zweiten Transistors (T_{S2}) ein Widerstand (R₁) geschaltet ist.

11. Schaltungsanordnung nach Anspruch 10, dadurch gekennzeichnet, daß der Widerstand (R₁) durch einen Kondensator (C) ergänzt ist.

12. Schaltungsanordnung nach einem der Ansprüche 1 oder 3, dadurch gekennzeichnet, daß der Ausgang der Stromquellenschaltung einerseits mit der Anode einer ersten Freilaufdiode (D_{F1}), deren Kathode an der ersten Betriebsspannung (U_{V1}) des Verstärkers (V) liegt, verbunden ist, andererseits an die Kathode einer zweiten Freilaufdiode (D_{F2}) angeschlossen ist, deren Anode auf die zweite Betriebsspannung (U_{V2}) des Verstärkers (V) führt.

13. Schaltungsanordnung nach Anspruch 2, dadurch gekennzeichnet, daß die Schaltungsanordnung im AB-Betrieb läuft.

14. Schaltungsanordnung nach einem der Ansprüche 2 oder 4, dadurch gekennzeichnet, daß der Ausgang jeder Stromquellenschaltung in einen Rückkopplungspfad einbezogen ist.

## Claims

1. Circuit configuration for reducing power consumption in an analog amplifier which controls a linear or nonlinear complex load, it being possible to send a first (U_{V1}) and a second (U_{V2}) supply voltage of different polarity to the amplifier,
characterised in that
- the output of the amplifier is connected to the input of a current source circuit which is connected via its output to the load and to which supply voltages can be sent,
- at least one of the supply voltages (U_{S1}; U_{S2}) of the current source circuit is quantitatively lower than the amplifier supply voltage (U_{V1}; U_{V2}) corresponding to it in terms of its polarity, the other supply voltage (U_{S1}; U_{S2}) of the current source circuit being quantitatively no higher than the other amplifier supply voltage (U_{V2}; U_{V1}), and
- in dependence on the output voltage of the amplifier, when power is being output to the load, the current source circuit
- either makes a conductive connection between its input and its output whenever the output voltage of the amplifier, given identical polarity in each case, is higher than the supply voltage of the current source circuit, with the result that the amplifier delivers the load current, which flows through the current source circuit;
- or else operates as a linear amplifier, taking the load current out of its supply voltages whenever the output voltage of the amplifier, given identical polarity in each case, is no higher than the supply voltage of the current source circuit, with the result that the amplifier then only delivers a control current.

2. Circuit configuration according to claim 1, characterised in that the input of the current source circuit is connected on the one hand to the base of a first transistor (T_{S1}) whose collector leads to the cathode of a first diode (D_{S1}) and whose anode is at the first operating voltage (U_{S1}) and the emitter of the first transistor (T_{S1}) is connected to the load (L), and is connected on the other hand to the base of a second transistor (T_{S2}) whose collector is connected to the anode of a second diode (D_{S2}) whose cathode leads to the second operating voltage (V_{S2}), the emitter of the second transistor (T_{S2}) being linked to the load.

3. Circuit configuration for reducing power consumption in an analog amplifier which controls a linear or nonlinear complex load, it being possible to send a first (U_{V1}) and a second (U_{V2}) supply voltage of different polarity to the amplifier,
characterised in that
- the output of the amplifier is connected to the input of a current source circuit which is connected to the load via its output and to which a supply voltage can be sent,
- the supply voltage (U_{S1}) of the current source circuit is quantitatively lower than the amplifier supply voltage (U_{V1}; U_{V2}) corresponding to it in terms of its polarity, and
- in dependence on the output voltage of the amplifier, when power is being output to the load, the current source circuit
- either makes a conductive connection between its input and its output whenever the output voltage of the amplifier, given identical polarity, is higher than the supply voltage of the current source circuit, or else exhibits opposite polarity, with the result that the amplifier delivers the load current, which flows through the current source circuit;
- or else operates as a linear amplifier, taking the load current out of its supply voltages whenever the output voltage of the amplifier, given identical polarity, is no higher than the supply voltage of the current source circuit of opposite polarity, with the result that the amplifier then only delivers a control current.

4. Circuit configuration according to claim 3, characterised in that the input of the current source circuit is on the one hand connected to the base of a transistor (T_{S1}) whose collector leads to the cathode of a first diode (D_{S1}) and whose anode is at the first operating voltage (U_{S1}) and the emitter of the transistor (T_{S1}) is connected to the load (L), and that on the other hand the emitter of the transistor (T_{S1}) is connected to the anode of a further diode (D_{S9}) whose cathode is linked to the base of the transistor (T_{S1}).

5. Circuit configuration according to claim 1, characterised in that both supply voltages (U_{S1}; U_{S2}) of the current source circuit are quantitatively lower than the amplifier supply voltages (U_{V1}; U_{V2}).

6. Circuit configuration according to claim 1, characterised in that a plurality of cascaded current source circuits are wired between the amplifier and the load and that at least one of the supply voltages (U_{S3}; U_{S4}) of a second and, if appropriate, of a respective further current source circuit is quantitatively lower than the corresponding supply voltage (U_{S1}; U_{S2}) of the respective upstream current source circuit in terms of its polarity, the amount of the respective other supply voltage (U_{S4}; U_{S3}) being no greater than the amount of the other supply voltage (U_{S2}; U_{S1}) of the respective upstream current source circuit.

7. Circuit configuration according to claim 5, characterised in that both supply voltages (U_{S3}; U_{S4}) of a second and, if appropriate, of a respective further current source circuit are quantitatively lower than the supply voltages (U_{S1}; U_{S2}) of the respective upstream current source circuit.

8. Circuit configuration according to claim 2, characterised in that the collector of the first transistor (T_{S1}) is connected to the cathode of a third diode (D_{S3}), the anode of which leads to the base of the transistor (T_{S1}), whereas the collector of the second transistor (T_{S2}) is connected to the anode of a fourth diode (D_{S4}), the cathode of which is located at the base of said transistor.

9. Circuit configuration according to either of claims 2 or 4, characterised in that the transistors (T_{S1}, T_{S2}) are field effect transistors.

10. Circuit configuration according to claim 2, characterised in that a resistor (R₁) is wired between the base and the emitter of the first transistor (T_{S1}) or of the second transistor (T_{S2}).

11. Circuit configuration according to claim 10, characterised in that the resistor (R₁) is complemented by a capacitor (C).

12. Circuit configuration according to either of claims 1 or 3, characterised in that the output of the current source circuit is connected on the one hand to the anode of a first free-wheeling diode (D_{F1}) whose cathode is at the first operating voltage (U_{V1}) of the amplifier (V), and on the other hand to the cathode of a second free-wheeling diode (D_{F2}) the anode of which leads to the second operating voltage (U_{V2}) of the amplifier (V).

13. Circuit configuration according to claim 2, characterised in that the circuit configuration runs in class AB operation.

14. Circuit configuration according to either of claims 2 or 4, characterised in that the output of each current source circuit is included in a feedback path.

## Revendications

1. Dispositif de circuit pour réduire la consommation d'énergie d'un amplificateur analogique, qui pilote une charge complexe, linéaire ou non linéaire, dans lequel peuvent être amenées à l'amplificateur une première (U_{V1}) et une seconde (U_{V2}) tensions d'alimentation de polarité différente,
caractérisé par le fait
- que la sortie de l'amplificateur est reliée à l'entrée d'un circuit de source de courant qui est relié à la charge par l'intermédiaire de sa sortie et auquel peuvent être amenées des tensions d'alimentation, et
- qu'au moins l'une des tensions d'alimentation (U_{S1} ; U_{S2}) du circuit de source de courant est, en valeur absolue, inférieure à la tension d'alimentation (U_{V1} ; U_{V2}) de l'amplificateur qui correspond en ce qui concerne sa polarité, étant précisé que l'autre tension d'alimentation (U_{S2} ; U_{S1}) du circuit de source de courant est, en valeur absolue, non supérieure à l'autre tension d'alimentation (U_{V2} ; U_{V1}) de l'amplificateur, et
- que le circuit de source de courant, lors d'une fourniture d'énergie à la charge, en fonction de la tension de sortie de l'amplificateur,
- soit réalise une liaison conductrice entre son entrée et sa sortie, si la tension d'alimentation de l'amplificateur est supérieure à la tension d'alimentation du circuit de source de courant avec, chacune, la même polarité, de sorte que c'est l'amplificateur qui fournit le courant de charge qui passe par le circuit de source de courant ;
- soit opère comme amplificateur linéaire et prélève le courant de charge à partir de ses tensions d'alimentation, si la tension de sortie de l'amplificateur n'est pas supérieure à la tension d'alimentation du circuit de source de courant avec, chacune, la même polarité, de sorte qu'alors l'amplificateur ne fournit qu'un courant de pilotage.

2. Dispositif de circuit selon la revendication 1, caractérisé par le fait que l'entrée du circuit de source de courant est reliée d'une part à la base d'un premier transistor (T_{S1}) dont le collecteur est relié à la cathode d'une première diode (D_{S1}) et dont l'anode se trouve à la première tension d'exploitation (U_{S1}) et que l'émetteur du premier transistor (T_{S1}) est relié à la charge (L) et d'autre part est relié à la base d'un second transistor (T_{S2}) dont le collecteur est relié à l'anode d'une seconde diode (D_{S2}) dont la cathode se trouve à la seconde tension d'exploitation (U_{S2}), l'émetteur du second transistor (T_{S2}) étant relié à la charge.

3. Dispositif de circuit pour réduire la consommation d'énergie d'un amplificateur analogique, qui pilote une charge complcxe, linéaire ou non linéaire, dans lequel peuvent être amenées à l'amplificateur une première (U_{V1}) et une seconde (U_{V2}) tensions d'alimentation de polarité différente,
caractérisé par le fait
- que la sortie de l'amplificateur est reliée à l'entrée d'un circuit de source de courant qui est relié à la charge par l'intermédiaire de sa sortie et auquel peut être amenée une tension d'alimentation, et
- que la tension d'alimentation (U_{S1}) du circuit de source de courant est, en valeur absolue, inférieure à la tension d'alimentation (U_{V1} ; U_{V2}) de l'amplificateur qui correspond en ce qui concerne sa polarité et
- que le circuit de source de courant, lors d'une fourniture d'énergie à la charge, en fonction de la tension de sortie de l'amplificateur
- soit réalise une liaison conductrice entre son entrée et sa sortie, si la tension de sortie de l'amplificateur, pour une même polarité, est supérieure à la tension d'alimentation du circuit de source de courant, soit présente une polarité opposée de sorte que c'est l'amplificateur qui fournit le courant de charge qui passe par le circuit de source de courant ;
- soit opère comme amplificateur linéaire et prélève le courant de charge à partir de ces tensions d'alimentation, si la tension de sortie de l'amplificateur, pour une même polarité, n'est pas supérieure à la tension d'alimentation du circuit de source de courant de polarités opposées, de sorte qu'alors l'amplificateur ne fournit qu'un courant de pilotage.

4. Dispositif de circuit selon la revendication 3, caractérisé par le fait que d'une part l'entrée du circuit de source de courant est reliée à la base d'un transistor (T_{S1}) dont le collecteur est relié à la cathode d'une première diode (D_{S1}) et dont l'anode se trouve à la première tension d'exploitation (U_{S1}) et l'émetteur du transistor (T_{S1}) est relié à la charge (L) et que d'autre part, l'émetteur du transistor (T_{S1}) cst relié à l'anode d'une autre diode (D_{S2}) dont la cathode est reliée à la base du transistor (T_{S1}).

5. Dispositif de circuit selon la revendication 1, caractérisé par le fait que les deux tensions d'alimentation (U_{S1} ; U_{S2}) du circuit de source de courant sont, en valeur absolue, inférieures aux tensions d'alimentation (U_{V1} ; U_{V2}) de l'amplificateur.

6. Dispositif de circuit selon la revendication 1, caractérisé par le fait qu'entre l'amplificateur et la charge sont mis en circuit plusieurs circuits de source de courant montés en cascade et qu'au moins l'une des tensions d'alimentation (U_{S3} ; U_{S4}) d'un second, et éventuellement d'un autre, respectif, circuit de source de courant, est, en valeur absolue, inférieure à la tension d'alimentation (U_{S1} ; Us2), qui correspond en ce qui concerne sa polarité, du circuit de source de courant respectif mis en circuit en amont, étant précisé que la valeur absolue de l'autre, respective, tension d'alimentation (U_{S4} ; U_{S3}) n'est pas supérieure à la valeur absolue de l'autre tension d'alimentation (U_{S2} ; U_{S1}) du circuit de source de courant respectif mis en circuit en amont.

7. Dispositif de circuit selon la revendication 5, caractérisé par le fait que les deux tensions d'alimentation (U_{S3} ; U_{S4}) d'un second, et éventuellement d'un autre, respectif, circuit de source de courant, sont, en valeur absolue, inférieures aux tensions d'alimentation (U_{S1} ; U_{S2}) du circuit de source de courant respectif mis en circuit en amont.

8. Dispositif de circuit selon la revendication 2, caractérisé par le fait que le collecteur du premier transistor (T_{S1}) est relié à la cathode d'une troisième diode (D_{S3}) dont l'anode est reliée à la base du transistor (T_{S1}), tandis que le collecteur du second transistor (T_{S2}) est relié à l'anode d'une quatrième diode (D_{S4}) dont la cathode est reliée à la base de ce transistor.

9. Dispositif de circuit selon l'une des revendications 2 ou 4, caractérisé par le fait que les transistors (T_{S1}, T_{S2}) sont des transistors à effet de champ.

10. Dispositif de circuit selon la revendication 2, caractérisé par le fait qu'entre la base et l'émetteur du premier transistor (T_{S1}) ou du second transistor (T_{S2}) est mise en circuit une résistance (R₁).

11. Dispositif de circuit selon la revendication 10, caractérisé par le fait que la résistance (R₁) est complétée par un condensateur (C).

12. Dispositif de circuit selon l'une des revendications 1 ou 3, caractérisé par le fait que la sortie du circuit de source de courant d'une part est reliée à l'anode d'une première diode à régime libre (D_{F1}) dont la cathode se trouve à la première tension d'exploitation (U_{V1}) de l'amplificateur (V), d'autre part est reliée à la cathode d'une seconde diode à régime libre (D_{F2}) dont l'anode se trouve à la seconde tension d'exploitation (U_{V2}) de l'amplificateur (V).

13. Dispositif de circuit selon la revendication 2, caractérisé par le fait que le dispositif de circuit s'utilise en installation embarquée.

14. Dispositif de circuit selon l'une des revendications 2 ou 4, caractérisé par le fait que le signal de sortie de chaque circuit de source de courant intervient sur un chemin de rétrocouplage.
